# EUROPEAN PATENT SPECIFICATION

(11) **EP 2 573 939 B1**
(45) Date of publication and mention of the grant of the patent: **26.12.2018**
(21) Application number: 11397521.3
(22) Date of filing: 20.09.2011
(51) Int. Cl.: H03H 1/00, H03H 7/46

(54) **Multimedia splitter-filter**
Multimedia Signalspalter
Filtre et circuit de séparation multimédia

(43) Date of publication of application: 27.03.2013
(73) Proprietor: Teleste Oyj, 20660 Littoinen (FI)
(72) Inventor: Viili, Ari, 21420 Lieto (FI); Rainesto, Mitja, 21110 Naantali (FI)
(74) Representative: Berggren Oy, Tampere

(56) References cited:
- EP-A2- 0 059 786
- US-A- 4 267 529
- US-A- 4 399 419
- US-A- 4 453 153

## Description

### Field of the invention

The present invention relates to multimedia outlets, and more particularly to an isolation arrangement for a multimedia wall outlet.

### Background of the invention

Multimedia wall outlets are used in cable television (CATV) networks in which RF signals, or at least the last part of the signal path, are transported via a coaxial cable. A multimedia wall outlet typically comprises connectors for TV, radio and data signals for supplying various broadcast and Internet applications to the subscribers of the CATV network.

In order to provide sufficient screening effectiveness, such multimedia wall outlets must comprise isolation means for preventing the RF signal travelling in the coaxial cable to suffer from various disturbances, and vice versa, for preventing the RF signal to cause disturbance in its surroundings. The IEC standard 60728 series specify various performance requirements for multimedia wall outlets, for example relating to overvoltage protection of isolation capacitors.

For example, a galvanic isolation protection shall be provided between the ground of the shield of the coaxial cable and the ground of the wall outlet. Traditionally, this has been implemented by providing a separate piece of coaxial cable in connection with the wall outlet, wherein the piece of coaxial cable is surrounded by a plurality of ferrite sleeves and an array of capacitors soldered with the shield of the coaxial cable. This simple implementation provides protection against leakage currents and ground loops, but in order to be efficient, it requires a quite large number of capacitors and ferrites.

Consequently, the implementation requires a significant space, and usually a separate casing is used to cover the isolation means. Therefore, it is difficult to install the outlet as a surface mounted wall outlet, since the implementation does not fit into a standard wall outlet frame; further space is required either beside the standard wall outlet frame within the wall or a housing extending from the wall towards the interior must be used.

EP0059786 discloses a multimedia wall outlet comprising separating means for separating multimedia signal components to their own frequency ranges and a filter element, through which RF signals from coaxial cable are conducted to separating means.

US4267529 discloses an apparatus for coupling a source of RF signals to a receiver and for providing immunity from interfering ambient signals, wherein the apparatus comprises a pi tubular filter.

US4453153 discloses a bleeder resistor to be used, for example, in an antenna isolator, wherein the antenna isolator comprises a pi tubular filter.

US4399419 discloses a shielding of an isolator, which also comprises a pi tubular filter.

Thus, there is a need for a less-space requiring isolation arrangement for a multimedia wall outlet.

### Summary of the invention

Now there has been invented an improved multimedia wall outlet with reduced-sized isolation means enabling the multimedia wall outlet to be easily installed in a standard wall outlet frame. As an aspect of the invention, there is provided a multimedia wall outlet, which is characterized by what is stated in the independent claim. Various embodiments of the invention are disclosed in the dependent claims.

According to the invention, there is provided a multimedia wall outlet configured to receive radio-frequency (RF) signals via a coaxial cable, the radio-frequency (RF) signals comprising multimedia signal components on their own frequency ranges, the wall outlet comprising separating means for separating said multimedia signal components to their own frequency ranges; and a pi tubular filter element configured to provide a galvanic isolation between a ground of a shield of the coaxial cable and a ground of the wall outlet, wherein said RF signals are conducted from the coaxial cable through said pi tubular filter element to said separating means,
wherein the said pi tubular filter element comprises a first tubular capacitor, a tubular ferrite operating as an inductor and a second tubular capacitor, said capacitors and ferrite residing within an outer metal tube and surrounding an inner metal tube, wherein
a wall of the inner metal tube is in contact with the ground of the shield of the coaxial cable supplying the RF signal, and a wall of the outer metal tube is in contact with the ground of the wall outlet, a diameter of the outer metal tube being less than 13 mm, the length of the outer metal tube being less than 18 mm and the length of the inner metal tube being less than 25 mm,
wherein a body of the wall outlet is provided with a cavity dimensioned to correspond to outer dimensions of the pi tubular filter element, such that the pi tubular filter element can be pressed in the cavity to be in a stable contact with the body of the wall outlet,
wherein the pi tubular filter element further comprises the outer metal tube being in a form of a cylinder, and the inner metal tube being inside the outer metal tube, the inner metal tube being longer than the outer metal tube and extending through a central hole in an end wall of the outer metal tube, said inner metal tube providing a passageway for a signal conductor arranged to conduct the RF signals through the pi tubular filter element,
wherein said multimedia signal components comprise a television signal, a radio signal and a data signal, and the wall outlet further comprises connectors for each of said multimedia signal components, and
a location of the cavity within the body of the wall outlet is selected such that an insulation distance of more than 2 mm is arranged between the pi tubular filter element, when situated in the cavity, and each of said connectors.

According to an embodiment, the cavity is provided with an opening for the signal conductor of the pi tubular filter element to be connected to the coaxial cable.

The arrangement according to the invention provides significant advantages. The reduced size of the multimedia wall outlet as a whole enables to install the wall outlet in a standard wall outlet frame without reserving additional space for the isolation means either beside the standard wall outlet frame or in front of it. The multimedia wall outlet can be easily and quickly installed into the frame. By getting rid of the large number of capacitors and ferrites, the manufacturing of multimedia wall outlet becomes simpler, faster and cheaper. Moreover, the tubular filter element provides excellent isolation properties and overvoltage protection, which are in compliance with the requirements of the IEC standard 60728 series.

These and other aspects of the invention and the embodiments related thereto will become apparent in view of the detailed disclosure of the embodiments further below.

### List of drawings

In the following, various embodiments of the invention will be described in more detail with reference to the appended drawings, in which
- Fig. 1: shows the basic principle of the isolation arrangement according to an embodiment of the invention;
- Fig. 2: shows a cross-sectional vertical view of the tubular filter element according to an embodiment of the invention;
- Figs. 3a, 3b and 3c: show schematic views of the components of the tubular filter element according to various embodiments of the invention; and
- Fig. 4: shows a schematic view of a multimedia wall outlet according to an embodiment of the invention.

### Description of embodiments

In the following, the invention will be illustrated by referring to multimedia wall outlets providing connectors for TV signals, FM radio signals and data signals. It is, however, noted that the invention is not limited to such wall outlets solely, but it can be implemented in any wall outlets, wherein RF signal is supplied to outlet via a coaxial cable.

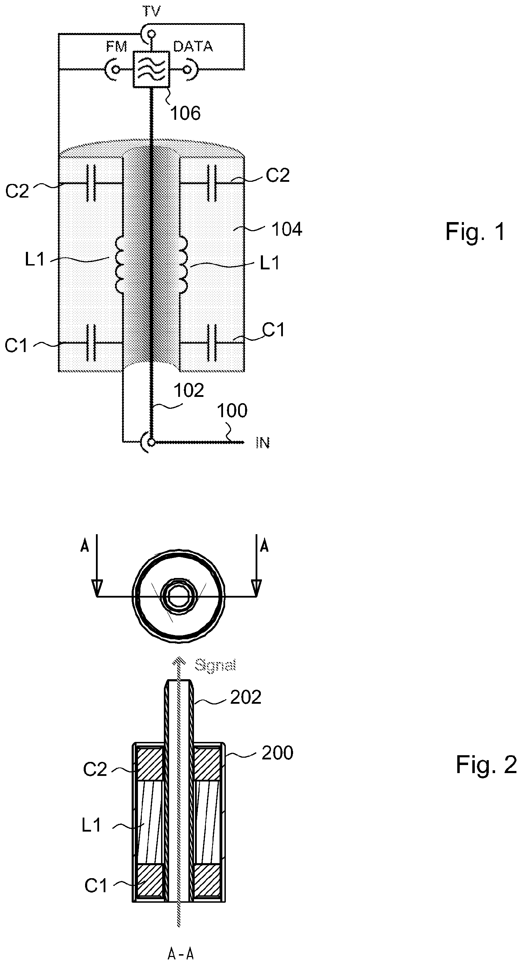

Figure 1 illustrates the basic principle of the isolation arrangement. The RF signal comprising the TV signals, the FM radio signals and the data signals, each on their own frequency range, is supplied from the CATV network via the coaxial cable 100. The RF signal is further connected to a signal conductor 102 of a tubular filter 104, thus supplying the RF signal through the tubular filter 104 to a TV/FM/data filter 106. The TV/FM/data filter 106 separates the TV signals, the FM radio signals and the data signals on their own frequency ranges, and it may be implemented as a bandpass triplexer filter.

The tubular filter 104 is implemented in a pi filter configuration, wherein the signal conductor 102 is tubularly surrounded by a first capacitor C1, an inductor L1 and a second capacitor C2, together forming a pi filter. Such pi filter circuit is generally known to be used to remove undesired frequencies from a signal. Herein, by galvanically isolating the ground of the shield of the coaxial cable and the ground of the wall outlet, undesired disturbances and leakage currents between the RF signal travelling in the coaxial cable and its surroundings are efficiently prevented.

Figure 2 shows a cross-sectional vertical view of the tubular filter element across the plane A-A dividing the element in the middle in vertical direction. The tubular filter element comprises an outer metal tube 200 in the form of a cylinder. Within the outer metal tube 200, there is an inner metal tube 202 which is longer than the outer metal tube 200 and extends through a central hole in an end wall of the outer metal tube 200. In the opposite end wall of the outer metal tube 200, the end of the inner metal tube 202 is arranged substantially in the same plane as the end wall of the outer metal tube. Within the outer metal tube 200, the inner metal tube 202 is surrounded by three tubular components; i.e. a first tubular capacitor C1, a tubular ferrite operating as an inductor L1 and a second tubular capacitor C2. The diameter of said tubular components is preferably substantially the same as the inner diameter of the outer metal tube 200. Said tubular components are naturally provided with a central hole, the diameter of which is preferably substantially the same as the outer diameter of the inner metal tube 202.

Regarding the size of the tubular filter element, the size of the multimedia wall outlet and the space available therein sets the limit for the maximum size of the tubular filter element. Experiments have shown that in order to have all the necessary components of the multimedia wall outlet fit in a standard wall outlet frame, the diameter of the outer metal tube 200 should be less than 13 mm, preferably less than 10 mm, and more preferably less than 7,5 mm.

The length of the outer metal tube 200 should be less than 18 mm, preferably less than 15 mm, and more preferably less than 12 mm. The length of the inner metal tube 202 should be less than 25 mm, preferably less than 20 mm, and more preferably less than 17 mm. The aim is to achieve a sufficiently small tubular filter element, but it is obvious that the electrical properties of the filter materials and the breakthrough voltage to be obtained (specified by the IEC standard 60728 series) by the filter components practically set the limit for the minimum size of the tubular filter element.

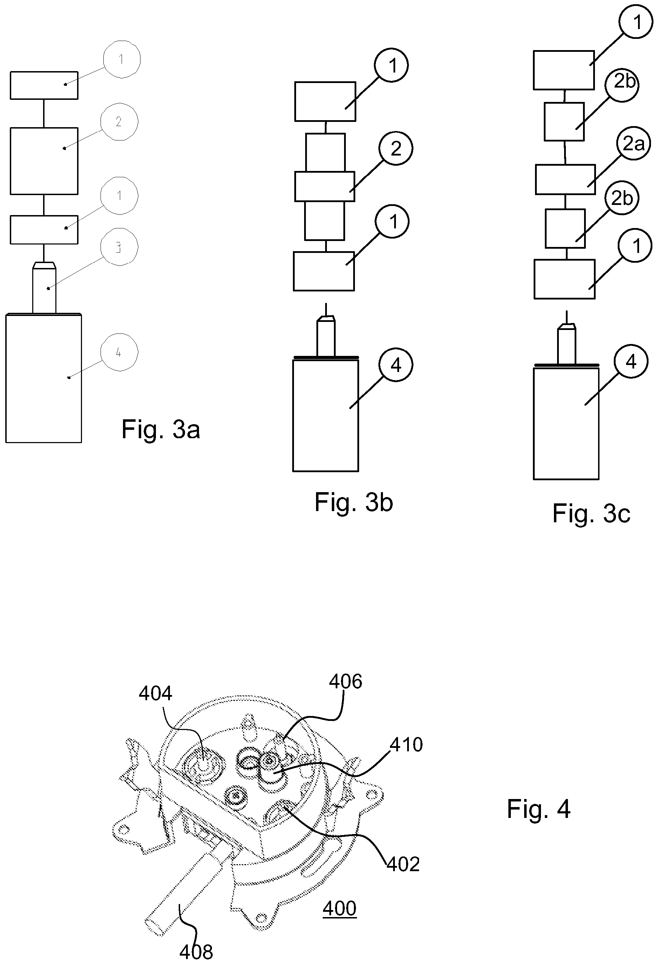

Figure 3a shows a schematic view of the components of the tubular filter element. The inner metal tube 3 provides the passageway for the signal conductor arranged to conduct the RF signal through the tubular filter. The wall of the inner metal tube is arranged to be connected to the shield of the coaxial cable supplying the RF signal from the CATV network, and thereby also connected to the ground of the shield of the coaxial cable. The inner metal tube 3 is surrounded by a first tubular capacitor 1, a tubular ferrite 2, and a second tubular capacitor 1. Said capacitors and said ferrite are surrounded by an outer metal tube 4. The wall of the outer metal tube is arranged to be connected to the ground of the wall outlet. The disk-like layered structure of Figure 3a enables to achieve excellent performance for the isolation and the screening effectiveness.

In order to achieve the isolation and the screening effectiveness according to the IEC standard 60728 series, the capacitance and the inductance of the filter components should be selected appropriately. According to an embodiment, the capacitance of both of said tubular capacitors is selected as C=4,7 nF with a tolerance of (-20/+80%) and the inductance of the ferrite is selected as L=800 nH (min). However, a person skilled in the art readily acknowledges that there are a plurality of other capacitance/inductance value combinations, which provide the sufficient isolation and the screening effectiveness required by IEC standard 60728 series.

The basic principle of the filter component arrangement shown in Figure 3a may be implemented in various ways. According to an embodiment shown in Figure 3b, the tubular ferrite 2 may be "doubleT-shaped" such that the ferrite has a wider section reaching the inner wall of the outer metal tube only in the middle of the component. The narrower sections at the both ends of the ferrite provide adaptations allowing the tubular capacitors 1 to be aligned over the narrower sections of the ferrite. The structure of Figure 3b is less expensive to implement than that of Figure 3a, and while being slightly inferior in performance, it still provides sufficient isolation and screening effectiveness.

Figure 3c shows a further implementation alternative for the filter component according to another embodiment. The filter component in Figure 3c is otherwise similar to that of Figure 3b, but the ferrite consists of three separate pieces: a wider ferrite 2a, and two narrower ferrites 2b located at the opposite sides of the wider ferrite. By selecting the electrical properties of the ferrites appropriately, it is easy to adjust the inductance produced by the ferrite components.

Figure 4 shows a schematic view of a multimedia wall outlet according to an embodiment, wherein the tubular filter element is used for reducing the size of the multimedia wall outlet. Figure 4 shows the backside (i.e. the side facing the wall) of the multimedia wall outlet 400, since the tubular filter element is not visible on the front side of the multimedia wall outlet. As shown in Figure 4, the multimedia wall outlet 400 is designed such that it fits in a standard wall outlet frame. The multimedia wall outlet comprises separate connectors for television signal, radio signal and data signal, said connectors facing the front side of the multimedia wall outlet. Figure 4 shows the rear sections of the connectors 402, 404, 406 for the television signal, the radio signal and the data signal, correspondingly. The signals are supplied from the network via the coaxial cable 408 (corresponds to the coaxial cable 100 in Figure 1).

The body of the multimedia wall outlet 400 is provided with a cavity, wherein the tubular filter element 410 is arranged e.g. by pressing it in its place. The cavity and the tubular filter element 410 are dimensioned such that the tubular filter element 410 is fit tightly in the body of the multimedia wall outlet, thereby ensuring a good and stable contact between the tubular filter element and the body of the multimedia wall outlet. Compared to prior art, said contact can be made more stable and durable in all installation circumstances. The dimensions and the location of the cavity are selected such that the insulation distances to the connectors are sufficient to prevent the breakthrough voltage to drop below that specified in the IEC standard 60728 series. The distance between the cavity and the connectors should be more than 2 mm.

The cavity is provided with an opening such that the coaxial cable 408 is connected to the signal conductor of the tubular filter 410, as is shown Figure 1, wherein the coaxial cable 100 is connected to the signal conductor 102 of the tubular filter 104. The overall connection of the tubular filter element is arranged as shown in Figure 1. The signal conductor of the tubular filter 410 is connected to a TV/FM/data filter (not shown), which separates the TV signals, the FM radio signals and the data signals on their own frequency ranges and the signals are then provided via their own conductors (not shown) to the rear sections of the connectors 402, 404, 406.

The isolation arrangement in connection with a multimedia wall outlet, as described above, provides significant advantages. The size of the multimedia wall outlet as a whole can be reduced such that the wall outlet can be installed in a standard wall outlet frame without reserving additional space for the isolation means outside the wall outlet frame. The installation of the multimedia wall outlet into the frame becomes easier and quicker. Also the manufacturing of multimedia wall outlet becomes simpler and faster, since installing and soldering the large number of capacitors and ferrites is not required anymore.

Furthermore, the multimedia wall outlet is cheaper to manufacture because of the significantly reduced number of required components. Regardless of its small size, the tubular filter element provides excellent isolation properties and overvoltage protection, which are in compliance with the requirements of the IEC standard 60728 series.

It is obvious that the present invention is not limited solely to the above-presented embodiments, but it can be modified within the scope of the appended claims.

## Claims

1. A multimedia wall outlet (400) configured to receive radio-frequency (RF) signals via a coaxial cable (100), the radio-frequency (RF) signals comprising multimedia signal components on their own frequency ranges, the wall outlet (400) comprising
separating means (106) for separating said multimedia signal components to their own frequency ranges; **characterized in that** the wall outlet (400) comprises
a pi tubular filter element (104) configured to provide a galvanic isolation between a ground of a shield of the coaxial cable (100)
and a ground of the wall outlet (400), wherein said RF signals are conducted from the coaxial cable (100) through said pi tubular filter element (104) to said separating means (106), wherein the said pi tubular filter element (104) comprises a first tubular capacitor (C1), a tubular ferrite (L1) operating as an inductor and a second tubular capacitor (C2), said capacitors and ferrite residing within an outer metal tube (200) and surrounding an inner metal tube (202), wherein
a wall of the inner metal tube (202) is in contact with the ground of the shield of the coaxial cable (100) supplying the RF signal, and a wall of the outer metal tube (200) is in contact with the ground of the wall outlet (400), a diameter of the outer metal tube (200) being less than 13 mm, the length of the outer metal tube (200) being less than 18 mm and the length of the inner metal tube (202) being less than 25 mm,
wherein a body of the wall outlet is provided with a cavity dimensioned to correspond to outer dimensions of the pi tubular filter element (104), such that the pi tubular filter element (104) can be pressed in the cavity to be in a stable contact with the body of the wall outlet (400),
wherein the pi tubular filter element (104) further comprises the outer metal tube (200) being in a form of a cylinder, and the inner metal tube (202) being inside the outer metal tube (200), the inner metal tube being longer than the outer metal tube (200) and extending through a central hole in an end wall of the outer metal tube (200), said inner metal tube (202) providing a passageway for a signal conductor (102) arranged to conduct the RF signals through the pi tubular filter element (104), wherein said multimedia signal components comprise a television signal, a radio signal and a data signal, and the wall outlet further comprises connectors (402, 404, 406) for each of said multimedia signal components, and
a location of the cavity within the body of the wall outlet (400) is selected such that an insulation distance of more than 2 mm is arranged between the pi tubular filter element (104), when situated in the cavity, and each of said connectors (402, 404, 406).

2. The wall outlet according to claim 1, wherein
the cavity is provided with an opening for the signal conductor of the pi tubular filter element (104) to be connected to the coaxial cable (100).

## Patentansprüche

1. Multimedia-Wandsteckdose (400), die dafür ausgestaltet ist, Radiofrequenz (RF) Signale über ein Koaxialkabel (100) zu empfangen, wobei die Radiofrequenz (RF) Signale Multimedia-Signalkomponenten in ihren eigenen Frequenzbereichen umfassen, wobei die Wandsteckdose (400) Folgendes umfasst:
ein Trennmittel (106) zum Trennen der Multimedia-Signalkomponenten in ihre eigenen Frequenzbereiche;
**dadurch gekennzeichnet, dass** die Wandsteckdose (400) Folgendes umfasst:
ein Pi-Rohr-Filterelement (104), das dafür ausgestaltet ist, eine galvanische Isolierung zwischen einer Erde einer Abschirmung des Koaxialkabels (100) und einer Erde der Wandsteckdose (400) bereitzustellen,
wobei die RF Signale von dem Koaxialkabel (100) durch das Pi-Rohr-Filterelement (104) zu dem Trennmittel (106) geleitet werden, wobei
das Pi-Rohr-Filterelement (104) umfasst: einen ersten Rohrkondensator (C1), einen Rohrferrit (L1), der als eine Induktivität dient, und einen zweiten Rohrkondensator (C2), wobei die Kondensatoren und der Ferrit in einem äußeren Metallrohr (200) angeordnet sind und ein inneres Metallrohr (202) umgeben,
wobei eine Wand des inneren Metallrohres (202) in Kontakt mit der Erde der Abschirmung des Koaxialkabels (100) steht, welches das RF Signal zuführt, und
wobei eine Wand des äußeren Metallrohres (200) in Kontakt mit der Erde der Wandsteckdose (400) steht,
wobei ein Durchmesser des äußeren Metallrohres (200) kleiner ist als 13 mm, die Länge des äußeren Metallrohres (200) kleiner ist als 18 mm, und die Länge des inneren Metallrohres (202) kleiner ist als 25 mm,
wobei ein Körper der Wandsteckdose mit einem Hohlraum versehen ist, der so bemessen ist, dass er den Außenabmessungen des Pi-Rohr-Filterelements (104) entspricht, dergestalt, dass das Pi-Rohr-Filterelement (104) in den Hohlraum gepresst werden kann, so dass es in einem stabilen Kontakt mit dem Körper der Wandsteckdose (400) steht,
wobei das Pi-Rohr-Filterelement (104) des Weiteren das äußere Metallrohr (200) umfasst, das die Form eines Zylinders aufweist, und das innere Metallrohr (202) im Inneren des äußeren Metallrohres (200) angeordnet ist, wobei das innere Metallrohr länger ist als das äußere Metallrohr (200) und sich durch ein mittiges Loch in einer Endwand des äußeren Metallrohes (200) erstreckt, wobei das innere Metallrohr (202) einen Durchgang für einen Signalleiter (102) bereitstellt, der dafür ausgelegt ist, die RF Signale durch das Pi-Rohr-Filterelement (104) zu leiten,
wobei die Multimedia-Signalkomponenten ein Fernsehsignal, ein Radiosignal und ein Datensignal umfassen, und die Wandsteckdose des Weiteren Verbinder (402, 404, 406) für jede der Multimedia-Signalkomponenten umfasst, und
wobei eine Position des Hohlraums in dem Körper der Wandsteckdose (400) so gewählt ist, dass ein Isolierabstand von mehr als 2 mm zwischen dem Pi-Rohr-Filterelement (104), wenn es sich in dem Hohlraum befindet, und jedem der Verbinder (402, 404, 406) gebildet wird.

2. Wandsteckdose nach Anspruch 1, wobei der Hohlraum mit einer Öffnung für den Signalleiter des Pi-Rohr-Filterelements (104) versehen ist, um mit dem Koaxialkabel (100) verbunden zu werden.

## Revendications

1. Une prise murale multimédia (400) configurée de façon à recevoir des signaux radioélectriques (RF) par l'intermédiaire d'un câble coaxial (100), les signaux radioélectriques (RF) comprenant des composants de signaux multimédias sur leurs propres gammes de fréquence, la prise murale (400) comprenant
un moyen de séparation (106) destiné à la séparation desdits composants de signaux multimédias en leurs propres gammes de fréquence, **caractérisé en ce que** la prise murale (400) comprend
un élément filtrant tubulaire pi (104) configuré de façon à fournir une isolation galvanique entre une masse d'un blindage du câble coaxial (100) et une masse de la prise murale (400)
lesdits signaux RF étant conduits à partir du câble coaxial (100) par l'intermédiaire dudit élément filtrant tubulaire pi (104) vers ledit moyen de séparation (106),
ledit élément filtrant tubulaire pi (104) comprenant un premier condensateur tubulaire (C1), une ferrite tubulaire (L1) fonctionnant en tant qu'inducteur et un deuxième condensateur tubulaire (C2), lesdits condensateurs et ferrite résidant à l'intérieur d'un tube métallique extérieur (200) et entourant un tube métallique intérieur (202),
une paroi du tube métallique intérieur (202) étant en contact avec la masse du blindage du câble coaxial (100) fournissant le signal RF, et
une paroi du tube métallique extérieur (200) étant en contact avec la masse de la prise murale (400)
un diamètre du tube métallique extérieur (200) étant inférieur à 13 mm, la longueur du tube métallique extérieur (200) étant inférieure à 18 mm et la longueur du tube métallique intérieur (202) étant inférieure à 25 mm,
un corps de la prise murale étant muni d'une cavité dimensionnée de façon à correspondre à des dimensions extérieures de l'élément filtrant tubulaire pi (104), de sorte que l'élément filtrant tubulaire pi (104) puisse être pressé dans la cavité de façon à être en contact stable avec le corps de la prise murale (400),
l'élément filtrant tubulaire pi (104) comprenant en outre le tube métallique extérieur (200) qui est en forme de cylindre, et le tube métallique intérieur (202) étant à l'intérieur du tube métallique extérieur (200), le tube métallique intérieur étant plus long que le tube métallique extérieur (200) et s'étendant au travers d'un trou central dans une paroi d'extrémité du tube métallique extérieur (200), ledit tube métallique intérieur (202) fournissant une voie de passage pour un conducteur de signaux (102) agencé de façon à conduire les signaux RF au travers de l'élément filtrant tubulaire pi (104),
lesdits composants de signaux multimédias comprenant un signal de télévision, un signal radio et un signal de données, et la prise murale comprenant en outre des connecteurs (402, 404, 406) pour chacun desdits composants de signaux multimédias, et
un emplacement de la cavité à l'intérieur du corps de la prise murale (400) est sélectionné de sorte qu'une distance d'isolation supérieure à 2 mm est agencée entre l'élément filtrant tubulaire pi (104), lorsqu'il se trouve dans la cavité, et chacun desdits connecteurs (402, 404, 406).

2. La prise murale selon la revendication 1, dans laquelle
la cavité est munie d'une ouverture pour le conducteur de signaux de l'élément filtrant tubulaire pi (104) à raccorder au câble coaxial (100).
